# FASCICULE DE BREVET EUROPEEN

(11) **EP 3 144 704 B1**
(45) Date de publication et mention de la délivrance du brevet: **27.09.2023**
(21) Numéro de dépôt: 16185946.7
(22) Date de dépôt: 26.08.2016
(51) Int. Cl.: G01T 1/24, G01N 21/3581, H01L 27/146, H01L 25/16, G06V 10/145

(54) **DISPOSITIF DE PRISE D'IMAGE A ECLAIRAGE INTEGRE ET PROCEDE DE REALISATION DU DISPOSITIF**
VORRICHTUNG ZUR BILDERFASSUNG MIT INTEGRIERTER BELEUCHTUNG, UND HERSTELLUNGSVERFAHREN DIESER VORRICHTUNG
IMAGE SENSOR DEVICE WITH INTEGRATED LIGHTING AND METHOD FOR PRODUCING THE DEVICE

(30) Priorité: 28.08.2015 FR 1558025
(43) Date de publication de la demande: 22.03.2017
(73) Titulaire: COMMISSARIAT À L'ÉNERGIE ATOMIQUE ET AUX ÉNERGIES ALTERNATIVES, 75015 Paris (FR)
(72) Inventeur: SEGURA PUCHADES, Josep, FONTAINE 38600 (FR)
(74) Mandataire: Atout PI Laplace

(56) Documents cités:
- WO-A1-2006/026796
- US-A1- 2013 119 237

## Description

L'invention concerne un dispositif de prise d'image destiné à réaliser des images d'un objet en contact ou à proximité immédiate avec le dispositif. L'invention concerne également un procédé de réalisation de ce dispositif. Ce type de dispositif peut être employé dans de nombreux domaines, comme dans l'imagerie médicale pour réaliser images de tissus vivants, dans la reconnaissance de personnes, par exemple pour des capteurs d'empreintes digitales, dans le contrôle de matériaux...

La réalisation d'une image nécessite un capteur possédant plusieurs éléments sensibles à un rayonnement. Ces éléments sensibles sont appelés pixels et sont généralement organisés en matrice. Chaque pixel fournit un signal représentatif du rayonnement qu'il reçoit. Un assemblage des signaux provenant des différents pixels permet de former une image bidimensionnelle dont les dimensions sont fonction du nombre et de l'organisation des pixels dans la matrice.

Dans le cadre de l'invention, le rayonnement auquel le capteur est sensible peut être de toute nature, comme par exemple un rayonnement électromagnétique dont toute fréquence peut être mise en oeuvre depuis les rayonnements ionisants gamma ou X jusqu'aux rayonnements de type Téra-Hertz.

Les pixels reçoivent un rayonnement issu d'un objet dont on veut réaliser une image. Ce rayonnement peut être réfléchi par l'objet ou issu d'une stimulation comme par exemple dans le cas de la fluorescence. Pour obtenir cette réflexion ou cette stimulation, une source de rayonnement incident est nécessaire. Lorsque le dispositif de prise d'image est à proximité immédiate de l'objet dont on veut obtenir l'image, la source est avantageusement intégrée au dispositif. L'invention s'intéresse plus particulièrement aux dispositifs à source intégrée.

Dans les dispositifs de petite taille, il est possible de placer la source de rayonnement incident à la périphérie du capteur. Afin d'homogénéiser l'éclairement, il est possible de disposer autour du capteur plusieurs sources ponctuelles. Cette disposition ne permet néanmoins pas d'homogénéiser complètement l'éclairement. En effet, les pixels situés au centre du capteur sont beaucoup plus éloignés des sources de lumières que les pixels situés à la périphérie et les différences d'éclairement peuvent être préjudiciables pour l'image issue d'un capteur ainsi réalisé.

Afin de rapprocher les pixels de la source de lumière, il est également possible de réduire la taille du capteur. Pour réaliser une image de grande taille, il est alors possible de juxtaposer plusieurs capteurs en laissant subsister un interstice entre les capteurs. On peut alors disposer une source de lumière dans l'interstice. La présence de plusieurs capteurs entraine des difficultés de positionnement des capteurs entre eux pour les aligner. Le nombre de capteurs et les difficultés de positionnement tendent à augmenter le coût du dispositif.

On a également tenté de réaliser un capteur partiellement transparent au rayonnement de la source de rayonnement incident comme par exemple décrit dans le document US 2013/119237 A1. Plus précisément, le capteur peut être transparent entre les pixels. La source de rayonnement n'est pas ponctuelle. Elle s'étend sur toute la surface du capteur. Ce mode de réalisation présente néanmoins plusieurs inconvénients :
- On est tenu de réduire le facteur de remplissage du capteur pour prévoir une surface suffisante de passage pour le rayonnement entre les pixels. Autrement dit, on est tenu de réduire la surface utile des pixels, ce qui pénalise la sensibilité du dispositif.
- Le rayonnement traversant le capteur peut être directement capté par les éléments photosensibles des pixels, ce qui n'est pas souhaité.
- Le coût d'un tel dispositif augmente avec la difficulté à réaliser une source de rayonnement répartie et l'obligation de protéger les pixels un rayonnement direct issu de la source.
- Même si le rayonnement issu de la source n'est pas directement capté par les éléments sensibles, des courants parasites peuvent être générés par l'éclairement dans des composants, tel que des transistors, présents dans chacun des pixels en complément de l'élément sensible.

Une autre alternative plus ancienne est décrite dans le document US 2007/292307 A1. Elle consiste à disposer sur un même substrat des éléments photosensibles et des diodes électroluminescentes. En pratique cette architecture nécessite de partager des pistes entre les éléments photosensibles et des diodes électroluminescentes et à ce jour, il n'existe pas de technologie à coût raisonnable pour mettre en oeuvre cette disposition. De plus, il est difficile de réaliser sur un même substrat des commandes différenciées entre les éléments photosensibles et les diodes électroluminescentes.

L'invention vise à pallier tout ou partie des problèmes cités plus haut en proposant un dispositif de prise d'image à faible coût dont le capteur est monobloc.

A cet effet, l'invention a pour objet un dispositif de prise d'image comprenant un capteur et des moyens d'éclairage pouvant émettre un premier rayonnement destiné à éclairer un objet pour en obtenir une image, le capteur comprenant des pixels sensibles à un second rayonnement fonction du premier rayonnement émis par les moyens d'éclairage, les pixels étant organisés de façon matricielle, caractérisé en ce que le capteur est formé sur un premier substrat monobloc comprenant plusieurs passages transparents au premier rayonnement, chacun des passages occupant la position d'au moins un pixel manquant dans l'organisation matricielle, en ce que les moyens d'éclairage comprennent un second substrat parallèle au premier substrat et portant plusieurs sources de premier rayonnement, et en ce qu'une des sources de premier rayonnement est disposée en regard de chacun des passages.

Chacun des passages peut occuper la position de plusieurs pixels contigus.

Les passages sont avantageusement répartis de façon uniforme dans l'organisation matricielle afin d'améliorer l'homogénéité de l'éclairement de l'objet.

Les pixels contigus des passages peuvent être inactifs. La neutralisation de ces pixels est avantageuse par exemple pour y faire passer des conducteurs de pilotage ou de lecture d'autres pixels.

Le dispositif peut comprendre des composants permettant le pilotage et la lecture des pixels. Le capteur comprend alors des pistes raccordant chacun des pixels aux composants, chaque piste étant routée en suivant une rangée de pixels. Pour les rangées interrompues par des passages, les pistes correspondantes peuvent être déviées autour des passages par des rangées voisines non interrompues.

Le substrat comprend une face avant portant pixels, et une face arrière opposée à la face avant. Le capteur peut comprendre un masque opaque au premier rayonnement, le masque étant disposé sur la face arrière.

Le premier substrat et le second substrat sont avantageusement flexibles, par exemple pour épouser la forme de l'objet.

Le second substrat comprend une face avant disposée en regard du capteur. Les moyens d'éclairage peuvent comprendre un masque opaque au rayonnement émis par la au moins une source de premier rayonnement, le masque étant disposé sur la face avant, le masque des moyens d'éclairage étant ajouré en regard des passages.

La au moins une source de premier rayonnement peut être disposée en contact à celui-ci.

Chacun des passages peut être une ouverture traversant le premier substrat ou une zone transparente du premier substrat

L'invention a également pour objet un procédé de réalisation d'un dispositif selon l'une des revendications précédentes, caractérisé en ce qu'il comprend les étapes suivantes :
- réaliser le capteur à partir du premier substrat,
- réaliser les moyens d'éclairage à partir du second substrat,
- puis assembler le capteur et les moyens d'éclairage.

L'invention sera mieux comprise et d'autres avantages apparaîtront à la lecture de la description détaillée d'un mode de réalisation donné à titre d'exemple, description illustrée par le dessin joint dans lequel :
la figure 1 représente un exemple de capteur pouvant être mis en oeuvre dans un dispositif conforme à l'invention ;
les figures 2a et 2b représentent plus précisément, autour d'un passage du capteur de la figure 1, le routage de conducteurs permettant de piloter les pixels du capteur ;
la figure 3 représente, toujours autour d'un passage, une variante de capteur dans laquelle le passage est plus grand que celui représenté sur les figures 2a et 2b ;
la figure 4 représente en vue éclatée un dispositif selon l'invention ;
les figures 5a, 5b et 5d
représentent plusieurs variantes de réalisation de moyens d'éclairage mis en oeuvre dans un dispositif selon l'invention ; la figure 5c représente une variante de réalisation de moyens d'éclairage mis en oeuvre dans un dispositif qui n'est pas incluse dans l'objet des revendications ;
les figures 6a, 6b et 6c représentent en coupe plusieurs variantes de dispositifs conforme à l'invention ;
la figure 7 représente en vue éclatée un autre dispositif qui n'est pas inclus dans l'objet des revendications;
les figures 8a et 8b représentent un exemple de dispositif selon l'invention mis en oeuvre pour une analyse biomédicale ;
la figure 9 représente un autre exemple de dispositif mis en oeuvre pour une analyse de matériau ;
la figure 10 représente des étapes de réalisation d'un dispositif conforme à l'invention.

Par souci de clarté, les mêmes éléments porteront les mêmes repères dans les différentes figures.

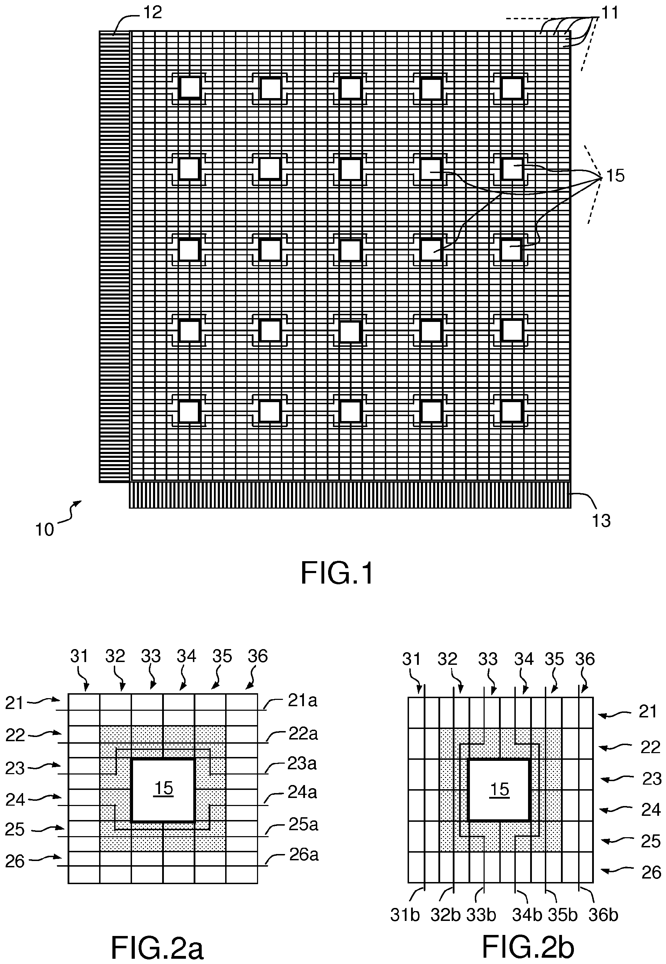

La figure 1 représente un capteur 10 formé sur un substrat monobloc. Le capteur 10 comporte des pixels 11 sensibles à un rayonnement, par exemple un rayonnement électromagnétique. Les pixels 11 sont, dans l'exemple représenté, régulièrement répartis à la surface du capteur 10. Les pixels sont organisés en matrice formée de lignes et de colonnes de pixels 11. D'autres organisations irrégulières sont également possibles dans le cadre de l'invention. Sur la figure 1 chaque pixel a la forme d'un carré. Les pixels 11 sont considérés comme jointifs. Dans la pratique, un pixel comprend un élément sensible au rayonnement et généralement un ou plusieurs composants, nécessaires au fonctionnement du pixel, comme par exemple un ou plusieurs transistors. Dans chacun des carrés représentés sur la figure 1, sont disposés un élément sensible et le ou les composants associés. Dans la surface d'un carré, on peut également trouver des pistes permettant de véhiculer des signaux de ou vers chaque pixel. En périphérie du capteur, sur le substrat, sont prévues des composants spécifiques répartis dans deux zones 12 et 13. Ces composants permettent notamment le pilotage et la lecture de la matrice de pixels 11. Les composants spécifiques peuvent être déportés sur un autre substrat. Les zones 12 et 13 forment alors des zones de connexion entre les pixels 11 et les composants spécifiques déportés. Dans l'exemple représenté, deux zones apparaissent. Il est également possible de réaliser des capteurs possédant un autre nombre de zones.

Selon l'invention, le capteur comprend plusieurs passages 15 destinés à laisser passer chacun un rayonnement issu d'une source de rayonnement. Chacun des passages 15 occupe la position d'au moins un pixel 11 de l'organisation matricielle. Autrement dit au moins un pixel manquant forme un passage 15. Les passages 15 peuvent être des ouvertures traversant le substrat du capteur 10 comme par exemple des perçages réalisés dans le substrat. Alternativement il est possible de conserver un substrat plan continu. Les passages 15 sont alors réalisés sous forme de zones transparentes du substrat. Les passages peuvent occuper la position d'un seul pixel ou de plusieurs pixels 11 contigus. Dans l'exemple représenté, chaque passage 15 occupe un carré de deux fois deux pixels. D'autres dispositions sont possibles. On peut notamment prévoir des carrés de dimension plus importante ou même des rectangles (nombre de pixels différents dans les deux directions de la matrice. Les dimensions des passages sont choisies en fonction de celles des sources de rayonnement incident retenues. Les passages 15 sont traversant et permettent d'y disposer des sources de rayonnement incident destinées à éclairer un objet dont on souhaite réaliser une image au moyen du capteur 10.

Afin d'obtenir une bonne homogénéité de l'éclairement issu des sources de rayonnement incident, les passages 15 sont avantageusement répartis de façon uniforme dans la matrice de pixels. Plus précisément, le nombre de pixels 11, séparant deux passages 15 voisins, est identique pour tous les couples de passages voisins et ceci dans les deux directions de la matrice.

Chaque pixel 11 délivre une information fonction d'un rayonnement provenant de l'objet éclairé soit par réflexion du rayonnement incident sur l'objet soit par stimulation de l'objet par le rayonnement incident. Par la suite, on appellera : premier rayonnement, le rayonnement incident émis par les sources destinées à éclairer l'objet et second rayonnement le rayonnement provenant de l'objet.

Dans le capteur 10, au niveau de chaque passage 15, des pixels sont manquants. Pour obtenir une image complète de l'objet, il est possible de réaliser un traitement pour reconstruire l'information qui aurait du provenir des pixels manquant, par exemple à partir de moyennes d'informations issues des pixels 11 voisins.

Les figures 2a et 2b représentent partiellement le capteur 10 autour d'un passage 15. Les différents pixels 11 de la matrice sont reliés aux zones 12 et 13 par des pistes. Par exemple la zone 12 peut être utilisée pour piloter les pixels. Chaque ligne de pixels 11 est reliée par une ou plusieurs pistes à la zone 12. Il est par exemple possible de prévoir deux pistes par ligne de pixels 11, une piste permettant la remise à zéro des pixels 11 et une autre piste permettant la sélection de la ligne de pixels. De même, chaque colonne de pixels 11 est reliée par une ou plusieurs pistes à la zone 13. Pour chaque colonne, une piste peut relier les pixels 11 de la colonne à un circuit de lecture situé dans la zone 13. D'autres pistes peuvent être prévues en ligne ou en colonne pour l'alimentation des pixels.

Sur la figure 2a, une seule piste par ligne de pixel 11 est représentée pour ne pas surcharger la figure. De même sur la figure 2b, une seule piste par colonne de pixel 11 est représentée. Lorsque plusieurs pistes sont nécessaires par ligne ou par colonne, elles suivent des routages parallèles. Pour assurer le croisement des pistes disposées en ligne et en colonne, celles-ci peuvent être disposées sur des couches différentes du substrat, couches séparées par un isolant.

Sur les figures 2a et 2b, sont représentées six lignes repérées 21 à 26 et six colonnes de pixels repérées 31 à 36. Sur la figure 2a, pour chaque ligne, la piste représentée est repérée par le repère de la ligne correspondante suivi de la lettre « a ». De même, sur la figure 2b, pour chaque colonne, la piste représentée est repérée par le repère de la colonne correspondante suivi de la lettre « b ». Les lignes 21, 22, 25 et 26 ne sont pas interrompues par un passage 15 et les pistes correspondantes 21a, 22a, 25a et 26a suivent les pixels 11 de leur ligne respective. Par contre, pour les lignes 23 et 24, des pixels sont manquants au niveau des colonnes 33 et 34. Ces quatre pixels manquants forment le passage 15. Le routage des pistes 23a et 24a est dévié dans les pixels situés au voisinage du passage 15 en suivant la ligne de pixel non interrompue la plus proche. Plus précisément, la piste 23a est déviée par les pixels de la ligne 22 et la piste 24a est déviée par les pixels de la ligne 25 au voisinage du passage 15.

De même, le routage des pistes 33b et 34b est dévié dans les pixels situés au voisinage du passage 15 en suivant la colonne de pixel non interrompue la plus proche. Plus précisément, la piste 33b est déviée par les pixels de la colonne 32 et la piste 34b est déviée par les pixels de la colonne 35 au voisinage du passage 15.

Les pixels contigus des passages 15 sont avantageusement inactifs, principalement du fait du routage particulier des pistes déviées passant par ces pixels. Sur les figures 2a et 2b, ces pixels situés à la périphérie du passage 15 sont représentés de façon grisée. En effet, ces pixels peuvent recevoir le premier rayonnement directement sans réflexion sur l'objet. Autrement dit ces pixels peuvent être éblouis par la source de rayonnement traversant le pixel 15. L'information qu'ils délivrent peut être erronée. Pour les rendre inactif, il est possible de supprimer l'élément sensible qu'ils contiennent, ce qui facilite le routage des pistes déviées. Alternativement, il est possible de conserver le même motif pour tous les pixels, actifs ou inactifs. Les pixels inactifs conservent donc chacun un élément sensible qui peut être connecté aux zones 12 et 13 comme pour les autres pixels. Le traitement de l'image est prévu pour ignorer l'information reçue des pixels 11 contigus aux passages 15. Comme pour les pixels manquant, l'image peut être reconstruite à partir des pixels 11 voisins actifs.

Alternativement, dans le cas d'un substrat continu comprenant des zones transparentes pour former les passages 15, il est possible de ne dévier aucune piste pour échapper aux passages 15. Plus précisément, au niveau de chaque passage 15, pour chaque pixel manquant, l'élément photosensible normalement prévu dans l'organisation matricielle est manquant et éventuellement les composants nécessaires au fonctionnement du pixel manquant. Seules les pistes prévues en ligne et en colonne subsistent en traversant le passage correspondant en ligne droite sans changement de direction au niveau du passage 15. Les pistes traversant les passages peuvent être opaques au rayonnement issu de la source de rayonnement. Le rayonnement issu de la source traverse le substrat par des zones libérées par l'absence d'élément photosensible et de composants nécessaires au fonctionnement du pixel manquant. Avantageusement, Il est possible de former ces pistes au moyen de conducteurs transparents au rayonnement issu de la source. Il est par exemple possible de mettre en oeuvre des oxydes conducteurs transparents, connus dans la littérature anglo-saxonne sous le nom de « transparent conductive oxides » ou « TCO ». Certains oxydes d'alliages métalliques tel que qu'un oxyde d'alliage d'étain de indium (Indium Tin Oxyde - ITO dans la littérature anglo-saxonne) sont également connus pour permettre la réalisation de conducteurs transparents.

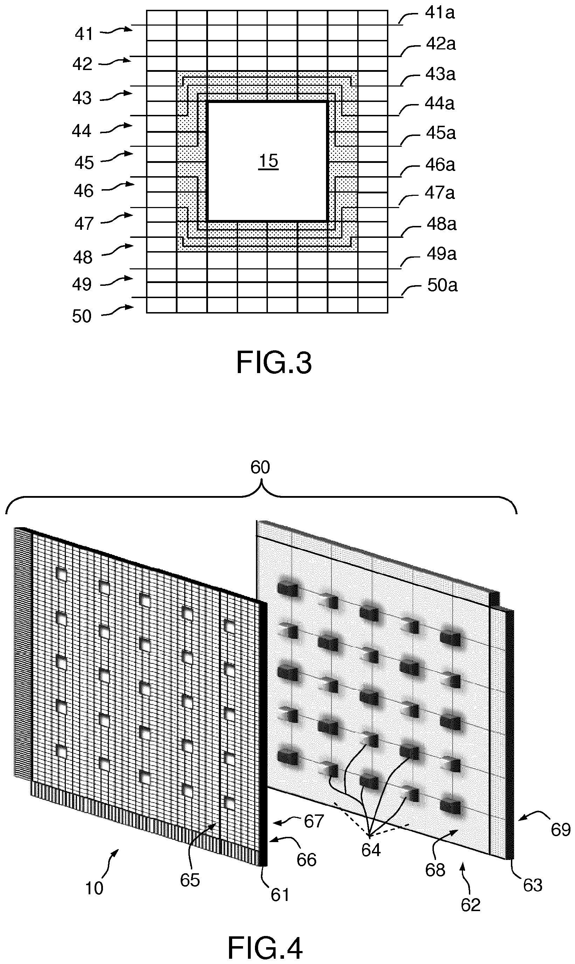

La figure 3 représente une variante de capteur dans laquelle le passage 15 est plus grand que celui représenté sur les figures 2a et 2b. Le passage représenté sur la figure 3 occupe une surface de quatre pixels par quatre pixels. Dix lignes repérées 41 à 50 sont représentées. Comme précédemment, pour chaque ligne, la piste représentée est repérée par le repère de la ligne correspondante suivi de la lettre « a ».

Les lignes 41, 42, 43, 48, 49 et 50 ne sont pas interrompues par un passage 15 et les pistes correspondantes 41a, 42a, 43a, 48a, 49a et 50a suivent les pixels 11 de leur ligne respective. Par contre, pour les lignes 44, 45, 46 et 47, des pixels sont manquants pour former le passage 15. Le routage des pistes 44a, 45a, 46a et 47a est dévié dans les pixels situés au voisinage du passage 15 en suivant la ligne de pixel non interrompue la plus proche. Plus précisément, les pistes 44a et 45a sont déviées par les pixels de la ligne 43 et les pistes 46a et 47a sont déviées par les pixels de la ligne 48 au voisinage du passage 15. Dans cette variante, trois pistes suivent les pixels de la ligne 43 et trois pistes suivent les pixels de la ligne 48 pour contourner le passage 15. Le même type de déviation au voisinage du passage 15 est réalisé pour les pistes circulant dans les colonnes de pixels.

Alternativement, il est possible de réduire le nombre de pistes circulant dans une même ligne de pixels en ne faisant cheminer par exemple au maximum que deux pistes par ligne de pixels, en ne routant par la ligne 43 que les pistes 44a et 45a. La piste 43a est déviée par la ligne 42 bien qu'elle ne comprenne pas de pixel manquant. Ainsi deux pistes suivent la ligne 43 et deux pistes suivent la ligne 42. Cette disposition permet de conserver une largeur de piste et une distance entre pistes voisines plus importante que dans la variante représentée sur la figure 3. Il est possible de rendre inactifs tous les pixels par lesquels transitent des pistes déviées.

La figure 4 représente en vue éclatée un dispositif de prise d'image 60 comprenant le capteur 10 réalisé sur un substrat 61. Le dispositif 60 comprend des moyens d'éclairage 62 d'un objet dont on souhaite obtenir l'image. Les moyens d'éclairage comprennent un substrat 63 et des sources 64 du premier rayonnement. Les deux substrats 61 et 63 sont par exemple disposés au contact l'un de l'autre. Le premier rayonnement traverse les passages 15 réalisés dans le substrat 61. Il est intéressant de disposer de deux substrat distincts 61 et 63, l'un pour le capteur 10 et l'autre pour les moyens d'éclairage 62 afin de bien séparer la fonction du capteur 10 qui est de porter les pixels et celle des moyens d'éclairage 62 qui est d'éclairer l'objet. Il est possible de placer sur une face arrière 66 du capteur 10, face opposée à une face avant 65 du capteur 10 portant les éléments sensibles, un masque 67 opaque au premier rayonnement afin de protéger les composants du capteur de tout éclairement direct provenant des moyens d'éclairage 62. Le masque 67 peut recouvrir toute la face arrière 67. Le masque 67 est interrompu par les passages 15. Le substrat 61 peut être réalisé dans un matériau transparent au rayonnement issu des moyens d'éclairage 62, comme par exemple du verre ou un matériau plastique transparent.

Les moyens d'éclairage 62 peuvent être formés d'une source de rayonnement uniformément répartie sur toute la surface du capteur 10. Néanmoins une bonne homogénéité de l'éclairement de ce type de source est délicate à mettre en oeuvre. L'éclairage peut notamment être affaibli au centre du capteur 10. Avantageusement, des sources 64 distinctes sont disposées en regard des passages 15. Autrement dit, une source 64 est disposée en regard de chacun des passages 15. Les sources 64 peuvent être formées de diodes électroluminescentes formant des sources quasi ponctuelles. Plus précisément, chaque source 64 possède des dimensions sensiblement égales à celles du passage 15 en regard de laquelle elle se trouve. Il est avantageux que les dimensions de chaque source 64 soient inférieures ou égale aux dimensions du passage 15 en regard, afin de limiter l'éclairage des pixels 11 jouxtant le passage 15 par le rayonnement issu de la source 64. Les sources 64 sont montées sur une face avant 68 du substrat 63 venant au contact de la face arrière 66 du capteur 10. Les sources 64 peuvent être proéminentes par rapport à la face avant 68 et s'insérer chacune dans un des passages 15. Les moyens d'éclairage 62 peuvent comprendre d'autres composants, notamment pour le fonctionnement des sources 64. A titre d'exemple, il peut s'agir de résistances de polarisation des diodes électroluminescentes utilisées comme sources 64 ou encore ou de transistors de sélection. De façon générale, ces autres composants sont avantageusement disposés sur une face arrière 69 du substrat 63, la face arrière 69 est opposée à la face avant 68.

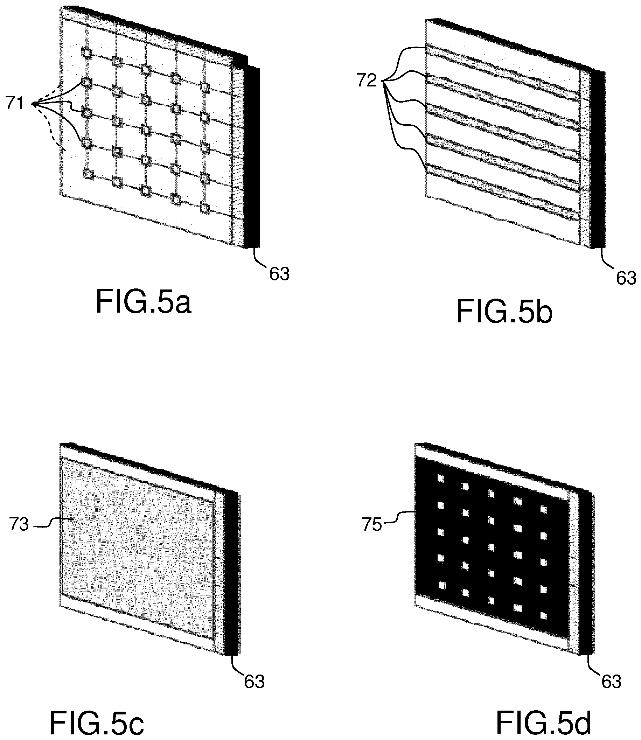

Les figures 5a à 5d représentent plusieurs variantes de réalisation des moyens d'éclairage 62 mettant en oeuvre des diodes électroluminescentes organiques notamment des diodes électroluminescentes à polymères connu dans la littérature anglo-saxonne sous l'acronyme PLED pour « Polymer Light-Emitting Diodes ». Certains polymères mis en oeuvre dans ce type de diodes restent sous forme liquide. Ils peuvent être déposés en couche mince sans nécessiter un dépôt sous vide. Le substrat 63 peut être flexible. Sur la figure 5a, plusieurs diodes 71 indépendantes sont déposées sur le substrat 63 et plus précisément sur sa face avant 68. La répartition des diodes 71 sur le substrat 63 correspond à la répartition des passages 15 sur le substrat 61. Les diodes 71 peuvent être pilotées individuellement ou par groupe. Sur la figure 5b, des diodes 72 sont réalisées en lignes correspondant chacune à une ligne de passage 15. Sur la figure 5c, une seule diode 73 occupe toute la surface du substrat 63. La figure 5d reprend la disposition des diodes 71, 72 ou 73. On a ajouté sur la face avant 68 un masque 75 opaque au rayonnement émis par les diodes. Le masque 75 est ajouré en regard des passages 15.

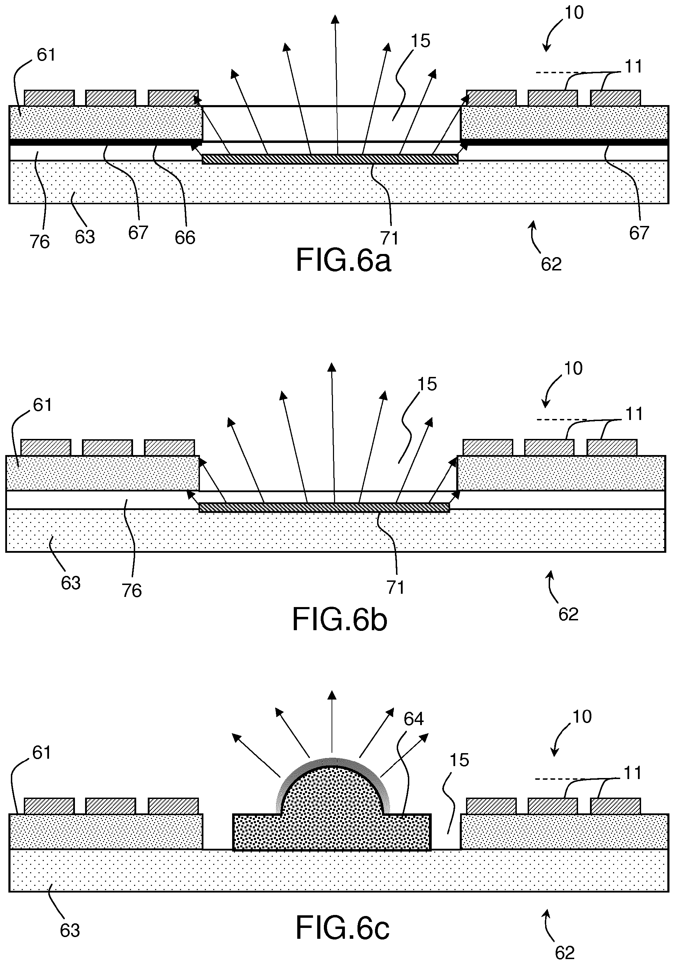

Les figures 6a, 6b et 6c représentent en coupe partielle plusieurs variantes de dispositifs selon l'invention. On y retrouve le capteur 10 et les moyens d'éclairage 62. Les coupes sont représentées dans un plan perpendiculaire au plan du capteur 10 au niveau d'un des passages 15 et des pixels 11 qui l'entourent. Dans les variantes des figures 6a et 6b, les moyens d'éclairage 62 comprennent, en regard de chaque passage 15, une diode électroluminescente organique 71 réalisée sur le substrat 63. Une couche d'encapsulation transparente 76 peut recouvrir l'ensemble du substrat 63 y compris la diode 71. Dans la variante de la figure 6a, le substrat 61 du capteur 10 est transparent au rayonnement émis par la diode 71. Le substrat 61 n'est pas interrompu pour former le passage 15. Le rayonnement émis par la diode 71 traverse le substrat 61. Un masque 67 est avantageusement disposé sur la face arrière 66 du capteur 10. Même en l'absence de masque 67, le fait que les diodes 71 ne soient disposées qu'en regard des passages 15 permet déjà d'éviter que les pixels 11 ne soient perturbés par le rayonnement émis par les moyens d'éclairage 62. Dans cette variante, certains pixels 11 jouxtant le passage 15 peuvent encore recevoir une partie du rayonnement émis par la diode 71 en traversant le substrat 61. Le masque 67 permet de limiter cette perturbation mais pas de la supprimer totalement.

Dans la variante de la figure 6b, le substrat 61 du capteur 10 est opaque au rayonnement émis par la diode 71. Le substrat 61 est interrompu pour former le passage 15. Dans cette variante, les pixels 11 jouxtant le passage 15 sont mieux protégés du rayonnement émis par la diode 71.

Dans la variante de la figure 6c, les sources 64 sont par exemple des diodes électroluminescentes montées en surface sur le substrat 63. Le substrat 61 du capteur 10 et également interrompu au niveau du passage 15. La diode électroluminescente 64 prend place à l'intérieur du passage 15.

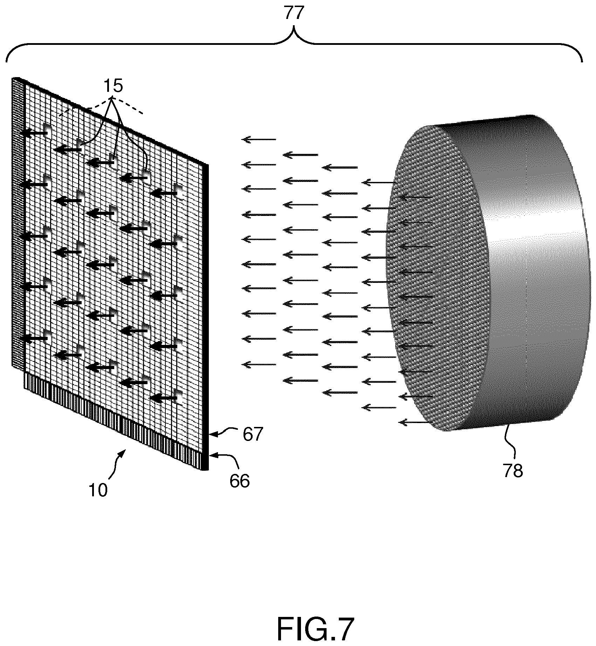

La figure 7 représente un autre mode de réalisation d'un dispositif de prise d'image 77 voisin du dispositif 60 représenté figure 4. Le dispositif 77 est adapté à l'imagerie en rayons X ou en rayons dits Téra-Hertz. Ces rayons Téra-hertz sont quelques fois appelés infrarouge lointains. Ils sont situés dans une bande de fréquence comprise entre les infrarouges proches du visible et les micro-ondes, typiquement entre 0,1 et 10 Téra-Hertz. Les rayons Téra-Hertz peuvent être utilisés pour dans le domaine du diagnostic médical, du contrôle non destructif ou de la sécurité.

On retrouve dans le dispositif 77 le capteur 10. Les moyens d'éclairage portent ici le repère 78. Il s'agit d'une source émettant un rayonnement dans la bande de fréquence retenue. La source 78 est disposée à distance du capteur 10 du coté de la face arrière 66. Le capteur 10 comprend également un masque 67 opaque au rayonnement issu de la source 78. Comme dans le dispositif 60, le rayonnement issu de la source 77 traverse les passages 15 pour éclairer un objet dont on souhaite obtenir l'image.

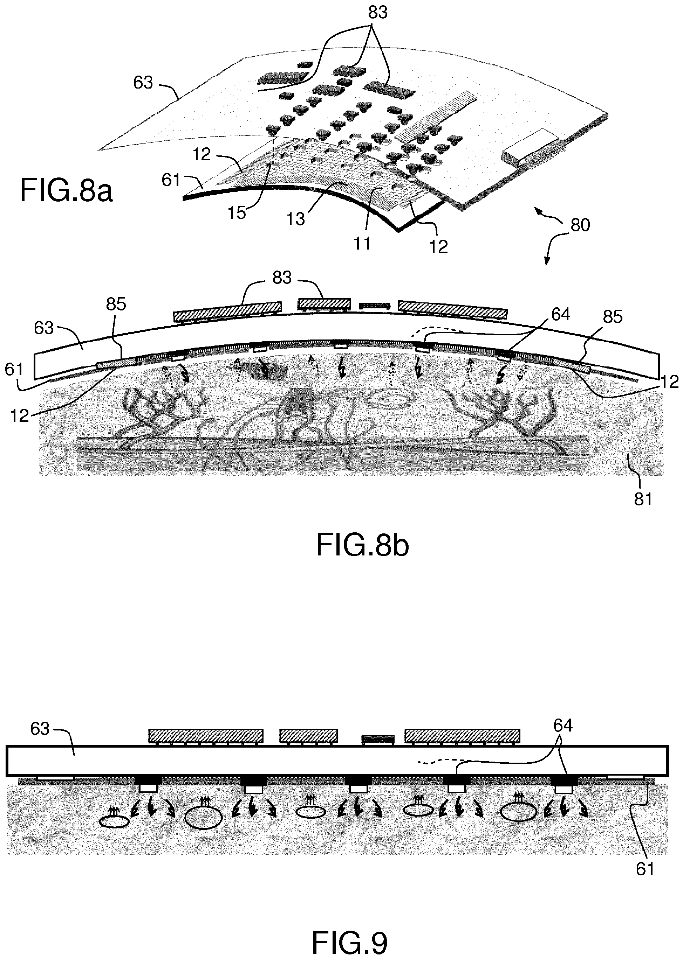

Les figures 8a et 8b représentent un exemple de dispositif de prise d'image 80 mis en oeuvre pour une analyse biomédicale. Le dispositif 80 est en contact avec la peau 81 d'un patient par exemple afin d'y détecter des tumeurs ou de localiser les artères et les veines. Les deux substrats 61 et 63 sont souples afin de rendre le dispositif 80 flexible pour épouser la surface de la peau 81. Les zones 12 et 13 forment des zones de connexion entre les pixels 11 disposés sur le substrat 61 et des composants 83 disposés sur le substrat 63. Les composants 83 permettent le pilotage des sources 64 et éventuellement des pixels 11 ainsi que leur lecture. Le substrat 63 comprend également des zones de connexion 85 en appui contre les zones de connexion 12 et 13 affin d'assurer un contact électrique entre elles. Les sources 64 sont par exemple des émetteurs infrarouges et les pixels 11 sont sensibles au rayonnement infrarouge réémis différemment en fonction de la nature biologique des tissus de la peau 81.

La figure 9 représente un autre exemple de dispositif de prise d'image mis en oeuvre pour une analyse de matériau. Le dispositif de la figure 7 est semblable au dispositif 80 des figures 6a et 6b. On y retrouve les deux substrats 61 et 63. Le substrat 61 est percé pour laisser passer les sources 64. Pour l'analyse de matériaux, les sources 64 peuvent être par exemple des sources de rayonnement visible, laser ou non, des points chauds réalisés à partir de résistances chauffantes, des émetteurs de rayonnement X... En pratique toute forme de source sensiblement ponctuelle peut être utilisée pour éclairer l'objet dont on souhaite une image.

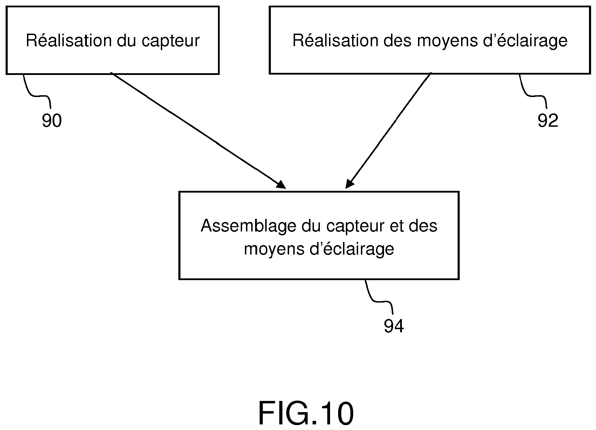

La figure 10 représente différentes étapes de réalisation d'un dispositif selon l'invention. Une étape 90 représente la réalisation du capteur 10 à partir de son substrat 61. Sur le substrat 61, sont par exemple gravées des pistes conductrices utilisées pour l'alimentation, le pilotage et la lecture des différents pixels 11 du capteur 10. Les composants des pixels, éléments photosensibles et autres composants, sont par exemple rapportés sur le substrat 61. Il est également possible de réaliser le capteur en couches minces déposées sur le substrat 61 en mettant en oeuvre un procédé de photolithographie.

Une étape 92 représente la réalisation des moyens d'éclairage 62 à partir de son substrat 63. Comme pour le capteur 10, les pistes nécessaires à l'alimentation des sources 64 peuvent être gravées sur le substrat 63, et les sources 64 peuvent, quant à elles, être montées en surface du substrat 63. Les sources 64 sont alors proéminentes par rapport au plan du substrat 63. Pour les variantes décrites à l'aide des figures 6a et 6b, les sources sont des diodes électroluminescentes organiques 71 par exemple réalisées en couches minces sur le substrat 63. Il est intéressant de séparer la réalisation du capteur 10 et des moyens d'éclairage 62 du fait de la nature différentes des éléments photosensibles du capteur 10 et des sources 64 des moyens d'éclairage 62, notamment lors de réalisation en couches minces.

Une étape 94 représente l'assemblage du capteur 10 et des moyens d'éclairage 62 une fois ceux-ci réalisés. Si les deux éléments à assembler sont réalisés en couches minces, leur épaisseur est sensiblement constante et l'assemblage peut se faire par collage. La colle mise en oeuvre est transparente aux rayonnements émis par les moyens d'éclairage 62. La colle est par exemple déposée sous forme de film. Le capteur 10 est ensuite pressé contre les moyens d'éclairage 62. Alternativement, dans la variante de la figure 6c, lors de l'assemblage du capteur 10 et des moyens d'éclairage 62, les diodes électroluminescentes 64 sont emboîtées dans les passages 15 du capteur 10. Toujours dans la variante de la figure 6c, les moyens d'éclairage 62 peuvent être collés au capteur 10 et la colle utilisée pour cet assemblage n'est pas obligatoirement transparente.

## Revendications

1. Dispositif de prise d'image comprenant un capteur (10) et des moyens d'éclairage (62) pouvant émettre un premier rayonnement destiné à éclairer un objet (81) pour en obtenir une image, le capteur (10) comprenant des pixels (11) sensibles à un second rayonnement fonction du premier rayonnement émis par les moyens d'éclairage (62), les pixels (11) étant organisés de façon matricielle, les pixels étant considérés comme jointifs, le capteur (10) étant formé sur un premier substrat (61) monobloc comprenant plusieurs passages (15) transparents au premier rayonnement, chacun des passages (15) occupant la position d'un ou plusieurs pixels (11) contigus de l'organisation matricielle, les moyens d'éclairage (62) comprenant un second substrat (63) parallèle au premier substrat (61) et portant plusieurs sources (64 ; 71 ; 72) de premier rayonnement, et les sources (64 ; 71 ; 72) de premier rayonnement étant chacune disposées en regard d'un des passages (15) ou emboîtées dans les passages (15).

2. Dispositif selon la revendication 1, **caractérisé en ce que** chacun des passages (15) occupe la position de plusieurs pixels (11) contigus.

3. Dispositif selon la revendication 2, **caractérisé en ce que** les passages (15) sont répartis de façon uniforme dans l'organisation matricielle.

4. Dispositif selon l'une des revendications 2 ou 3, **caractérisé en ce que** les pixels (11) contigus des passages (15) sont inactifs.

5. Dispositif selon l'une des revendications 2 à 4, **caractérisé en ce qu'**il comprend des composants (12, 13, 83) permettant le pilotage et la lecture des pixels (11), **en ce que** le capteur (10) comprend des pistes (21a à 26a, 31b à 36b; 41a à 50a) raccordant chacun des pixels (11) aux composants (12, 13, 83), chaque piste (21a à 26a, 31b à 36b ; 41a à 50a) étant routée en suivant une rangée (21 à 26, 31 à 36 ; 41 à 50) de pixels (11) et **en ce que** pour les rangées interrompues (23, 24, 33, 34 ; 44 à 47) par des passages (15), les pistes correspondantes (23a, 24a, 33a, 34a ; 44a à 47a) sont déviées autour des passages (15) par des rangées voisines non interrompues (22, 25, 32, 35 ; 43, 48).

6. Dispositif selon l'une des revendications précédentes, **caractérisé en ce que** le substrat (61) comprend une face avant (65) portant les pixels (11), et une face arrière (66) opposée à la face avant (65), et **en ce que** le capteur (10) comprend un masque (67) opaque au premier rayonnement, le masque (67) étant disposé sur la face arrière (66).

7. Dispositif selon l'une des revendications précédentes, **caractérisé en ce que** le premier substrat (61) et le second substrat (63) sont flexibles.

8. Dispositif selon l'une des revendications précédentes, **caractérisé en ce que** le second substrat (63) comprend une face avant (68) disposée en regard du capteur (10) et **en ce que** les moyens d'éclairage comprennent un masque (75) opaque au rayonnement émis par la au moins une source (64 ; 71 ; 72) de premier rayonnement, le masque (75) étant disposé sur la face avant (68), le masque (75) des moyens d'éclairage étant ajouré en regard des passages (15).

9. Dispositif selon l'une des revendications précédentes, **caractérisé en ce que** chacun des passages (15) est une ouverture traversant le premier substrat (61).

10. Dispositif selon la revendication 9, **caractérisé en ce que** les sources (64) sont proéminentes par rapport au second substrat (63) et sont emboîtées dans les passages (15).

11. Dispositif selon l'une des revendications 1 à 8, **caractérisé en ce que** chacun des passages (15) est une zone transparente du premier substrat (61).

12. Procédé de réalisation d'un dispositif selon l'une des revendications précédentes, **caractérisé en ce qu'**il comprend les étapes suivantes :
• réaliser le capteur (10) à partir du premier substrat (61),
• réaliser les moyens d'éclairage (62) à partir du second substrat (63),
• puis assembler le capteur (10) et les moyens d'éclairage (62).

## Patentansprüche

1. Bilderfassungsvorrichtung, umfassend einen Sensor (10) und Beleuchtungsmittel (62), die eine erste Strahlung aussenden können, die dazu bestimmt ist, ein Objekt (81) zu beleuchten, um davon ein Bild zu erhalten, wobei der Sensor (10) Pixel (11) umfasst, die für eine zweite Strahlung empfindlich sind, die von der ersten Strahlung abhängt, die von den Beleuchtungsmitteln (62) ausgesendet wird, wobei die Pixel (11) matrixförmig organisiert sind, wobei die Pixel als aneinanderstoßend betrachtet werden, wobei der Sensor (10) auf einem ersten einstückigen Substrat (61) gebildet wird, das mehrere für die erste Strahlung transparente Durchgänge (15) umfasst, wobei jeder der Durchgänge (15) die Position eines oder mehrerer aneinandergrenzender Pixel (11) der Matrixorganisation einnimmt, wobei die Beleuchtungsmittel (62) ein zweites Substrat (63) umfassen, das parallel zum ersten Substrat (61) verläuft und mehrere Quellen (64; 71; 72) der ersten Strahlung trägt, und wobei die Quellen (64; 71; 72) der ersten Strahlung jeweils gegenüber einem der Durchgänge (15) angeordnet oder in die Durchgänge (15) eingeschachtelt sind.

2. Vorrichtung nach Anspruch 1, **dadurch gekennzeichnet, dass** jeder der Durchgänge (15) die Position mehrerer aneinandergrenzender Pixel (11) einnimmt.

3. Vorrichtung nach Anspruch 2, **dadurch gekennzeichnet, dass** die Durchgänge (15) gleichmäßig über die Matrixorganisation verteilt sind.

4. Vorrichtung nach einem der Ansprüche 2 oder 3, **dadurch gekennzeichnet, dass** die an die Durchgänge (15) angrenzenden Pixel (11) inaktiv sind.

5. Vorrichtung nach einem der Ansprüche 2 bis 4, **dadurch gekennzeichnet, dass** sie Komponenten (12, 13, 83) zum Steuern und Auslesen der Pixel (11) umfasst, dass der Sensor (10) Spuren (21a bis 26a, 31b bis 36b; 41a bis 50a) umfasst, die jedes der Pixel (11) mit den Komponenten (12, 13, 83) verbinden, wobei jede Spur (21a bis 26a, 31b bis 36b; 41a bis 50a) entlang einer Reihe (21 bis 26, 31 bis 36; 41 bis 50) von Pixeln (11) geleitet ist, und dass bei den Reihen (23, 24, 33, 34; 44 bis 47), die durch Durchgänge (15) unterbrochen sind, die entsprechenden Spuren (23a, 24a, 33a, 34a; 44a bis 47a) um die Durchgänge (15) herum durch benachbarte, nicht unterbrochene Reihen (22, 25, 32, 35; 43, 48) umgeleitet werden.

6. Vorrichtung nach einem der vorhergehenden Ansprüche, **dadurch gekennzeichnet, dass** das Substrat (61) eine Vorderseite (65) umfasst, welche die Pixel (11) trägt, und eine Rückseite (66), die der Vorderseite (65) gegenüberliegt, und dass der Sensor (10) eine Maske (67) umfasst, die für die erste Strahlung undurchlässig ist, wobei die Maske (67) auf der Rückseite (66) angeordnet ist.

7. Vorrichtung nach einem der vorhergehenden Ansprüche, **dadurch gekennzeichnet, dass** das erste Substrat (61) und das zweite Substrat (63) flexibel sind.

8. Vorrichtung nach einem der vorhergehenden Ansprüche, **dadurch gekennzeichnet, dass** das zweite Substrat (63) eine Vorderseite (68) umfasst, die gegenüber dem Sensor (10) angeordnet ist, und dass die Beleuchtungsmittel eine Maske (75) umfassen, die für die von der mindestens einen Quelle (64; 71; 72) der ersten Strahlung emittierte Strahlung undurchlässig ist, wobei die Maske (75) auf der Vorderseite (68) angeordnet ist, wobei die Maske (75) der Beleuchtungsmittel gegenüber den Durchgängen (15) durchbrochen ist.

9. Vorrichtung nach einem der vorhergehenden Ansprüche, **dadurch gekennzeichnet, dass** jeder der Durchgänge (15) eine Öffnung ist, die das erste Substrat (61) durchquert.

10. Vorrichtung nach Anspruch 9, **dadurch gekennzeichnet, dass** die Quellen (64) in Bezug auf das zweite Substrat (63) vorstehen und in die Durchgänge (15) eingeschachtelt sind.

11. Vorrichtung nach einem der Ansprüche 1 bis 8, **dadurch gekennzeichnet, dass** jeder der Durchgänge (15) ein transparenter Bereich des ersten Substrats (61) ist.

12. Verfahren zur Herstellung einer Vorrichtung nach einem der vorhergehenden Ansprüche, **dadurch gekennzeichnet, dass** es die folgenden Schritte umfasst:
• Herstellen des Sensors (10) anhand des ersten Substrats (61),
• Herstellen der Beleuchtungsmittel (62) anhand des zweiten Substrats (63),
• anschließend Zusammenbauen des Sensors (10) und der Beleuchtungsmittel (62).

## Claims

1. An image capture device comprising a sensor (10) and illumination means (62) capable of emitting a first radiation intended to illuminate an object (81) to obtain an image thereof, the sensor (10) comprising pixels (11) that are sensitive to a second radiation dependent on the first radiation emitted by the illumination means (62), the pixels (11) being organised in a matrix, the pixels being considered to be contiguous, the sensor (10) being formed on a first monolithic substrate (61) comprising multiple passages (15) that are transparent to the first radiation, each of the passages (15) occupying the position of one or more contiguous pixels (11) from the matrix organisation, the illumination means (62) comprising a second substrate (63) parallel to the first substrate (61) and bearing multiple sources (64; 71; 72) of the first radiation, and the sources (64; 71; 72) of the first radiation being disposed so as to face one of the passages (15) or being fitted into the passages (15).

2. The device according to claim 1, **characterised in that** each of the passages (15) occupies the position of multiple contiguous pixels (11).

3. The device according to claim 2, **characterised in that** the passages (15) are uniformly distributed across the matrix organisation.

4. The device according to claim 2 or 3, **characterised in that** the pixels (11) that are contiguous with the passages (15) are inactive.

5. The device according to one of claims 2 to 4, **characterised in that** it comprises components (12, 13, 83) for controlling and reading out the pixels (11), **in that** the sensor (10) comprises tracks (21a to 26a, 31b to 36b; 41a to 50a) connecting each of the pixels (11) to the components (12, 13, 83), each track (21a to 26a, 31b to 36b; 41a to 50a) being routed along a row (21 to 26, 31 to 36; 41 to 50) of pixels (11), and **in that**, for the rows interrupted (23, 24, 33, 34; 44 to 47) by passages (15), the corresponding tracks (23a, 24a, 33a, 34a; 44a to 47a) are diverted around the passages (15) via neighbouring, uninterrupted rows (22, 25, 32, 35; 43, 48).

6. The device according to one of the preceding claims, **characterised in that** the substrate comprises (61) comprises a front face (65) bearing the pixels (11), and a rear face (66) opposite the front face (65), and **in that** the sensor (10) comprises a mask (67) that is opaque to the first radiation, the mask (67) being disposed on the rear face (66).

7. The device according to one of the preceding claims, **characterised in that** the first substrate (61) and the second substrate (63) are flexible.

8. The device according to one of the preceding claims, **characterised in that** the second substrate (63) comprises a front face (68) disposed so as to face the sensor (10) and **in that** the illumination means comprise a mask (75) that is opaque to the radiation emitted by the at least one source (64; 71; 72) of the first radiation, the mask (75) being disposed on the front face (68), the mask (75) of the illumination means being apertured opposite the passages (15).

9. The device according to one of the preceding claims, **characterised in that** each of the passages (15) is an aperture passing through the first substrate (61).

10. The device according to claim 9, **characterised in that** the sources (64) protrude with respect to the second substrate (63) and are fitted into the passages (15).

11. The device according to one of claims 1 to 8, **characterised in that** each of the passages (15) is a transparent zone of the first substrate (61).

12. A method for producing a device according to one of the preceding claims, **characterised in that** it comprises the following steps of:
• producing the sensor (10) from the first substrate (61),
• producing the illumination means (62) from the second substrate (63),
• then assembling the sensor (10) and the illumination means (62).
